# EUROPEAN PATENT APPLICATION

(11) **EP 1 221 753 A2**
(43) Date of publication of application: **10.07.2002**
(21) Application number: 02000353.9
(22) Date of filing: 04.01.2002
(51) Int. Cl.: H02J 7/02

(54) **A coreless superthin PCB transformer and noncontact battery charger using the same**

(30) Priority: 05.01.2001 KR 2001000512
(71) Applicant: Samsung Electronics Co., Ltd., Suwon-city, Kyungki-do (KR)
(72) Inventor: Park, Seo-Young, Pyeongtaek-shi, Kyonggi-do (KR); Park, Sang-Kyu, Gwacheon-shi, Kyonggi-do (KR); Choi, Byoung-Cho, Taegu-Kwangyok-shi (KR); Cha, Heon-Young, Yeongdeok-gun, Kyeongsangbuk-do (KR)
(74) Representative: Grünecker, Kinkeldey, Stockmair & Schwanhäusser Anwaltssozietät

(57) **Abstract**

A super-thin PCB (Printed Circuit Board) transformer is manufactured by installing windings on a common PCB without using a magnetic core. A non-contact battery charger using the PCB transformer includes a converter for converting a supply voltage into a high frequency square wave and then applying the converted square wave into a first winding of the PCB transformer; and a charger for converting an electromotive force to a DC voltage to apply the converted DC voltage to a charge circuit, the electromotive force being induced to a second winding of the PCB transformer by a magnetic wave which is generated by the square wave induced in the first winding of the PCB transformer. The non-contact battery charger can be applied to portable information communication and calculation devices such as a mobile telephone, a PDA (Personal Digital Assistant Device), a palm-top, an internetphone, etc.

## Description

The present invention relates to a battery charger, and more particularly, to a non-contact battery charger.

Portable intelligent communication and calculating devices, such as a mobile telephone, a personal digital assistant device (PDA), a palm-top computer, an internet phone, etc., which incorporate a rechargeable battery, essentially require a battery charger since use of the rechargeable battery as an energy source drains the battery, which then must either be recharged or replaced.

In currently commercialized desktop and portable battery chargers, a contact charging method is utilized where the battery and the battery charger are electrically contacted. However, the contact battery charger has several problems that must be solved.

First, problems such as an undercharged battery and deterioration of the battery leading to shortened battery lifetime should be solved. Second, exposure of communication devices to moisture or dust degrades the performance of a system. Third, the communication devices may malfunction due to static electricity generated by a contact of an externally exposed charging metal terminal with clothes of a user, thereby degrading the reliability of the device.

To solve these problems, a non-contact charging method has been developed to charge the battery by using magnetic coupling without electric contact. In the case where the battery charger is utilized with portable communication devices, a conventional transformer using a magnetic core is used as a magnetic coupling medium. In this case, a second side of the transformer manufactured at the magnetic core is usually mounted within the portable information device, which increases the size of the portable information device and places restrictions on the shape of the device. Moreover, the mechanical strength of the device is compromised due to the increased size and weight of the battery.

It is therefore the object of the present invention to provide a novel transformer which does not use a magnetic core thereby avoiding difficulties in reducing the size of a mobile terminal.

According to an aspect of the invention, there is provided a non-contact battery charger using the novel transformer.

According to an embodiment of the invention, to obtain the foregoing object, there is provided a PCB (Printed Circuit Board) transformer comprising: a first PCB having a first winding thereon; and a second PCB having a second winding thereon and being disposed at a distance from and parallel to the first PCB in a vertical direction, within a predetermined distance.

According to another embodiment of the invention, to obtain the foregoing objects, there is provided a non-contact battery charger comprising: a converter including a first side of a PCB transformer, is converting a supply voltage into a high frequency square wave and then applying the converted square wave to the first side of the PCB transformer; and a charger including a second side of the PCB transformer and having a charge circuit for converting an input voltage to a lower voltage and supplying the converted voltage to a battery, wherein the charger converts an electromotive force to a DC voltage to apply the converted DC voltage to the charge circuit, the electromotive force being induced to the second winding of the second PCB of the PCB transformer by a magnetic wave which is generated by the square wave induced in the first side of the PCB transformer.

The above object, features and advantages of the present invention will become more apparent in light of the following detailed description of an exemplary embodiment thereof taken in conjunction with the accompanying drawings, in which:
FIG. 1 is a perspective view showing the structure of a PCB transformer according to an embodiment of the invention;
FIG. 2 is a side elevational view of a non-contact battery charger for a mobile telephone using the PCB transformer shown in FIG. 1;
FIG. 3 is a perspective view showing a second side of the PCB transformer shown in FIG. 1 which is mounted to a battery pack surface;
FIG. 4 is a schematic view showing the structure of the non-contact battery charger for a mobile telephone according to an embodiment of the invention; and
FIG. 5 is a detailed circuit diagram showing a circuit of a non-contact battery charger for a mobile telephone according to another embodiment of the invention.

Hereinafter preferred embodiments will be described in detail with reference to the appended drawings. Reference numerals designated to components in the drawings should be understood whereby like components are referenced to by like numerals, even if shown in different drawings. While a number of specific elements such as detailed circuit devices are shown in the following description, it should be apparent to those skilled in the art that these specific elements are provided only for the overall understanding of the invention and the invention can be performed without these specific elements. Also, in describing the invention, detailed descriptions about known functions and configurations that may unnecessarily obstruct the aspect of the invention have been omitted.

The invention relates to a method for realizing non-contact charging of a battery by using a PCB transformer in which a winding of the PCB transformer is installed on a common PCB circuit, and the invention also relates to a circuit structure of a non-contact battery charger.

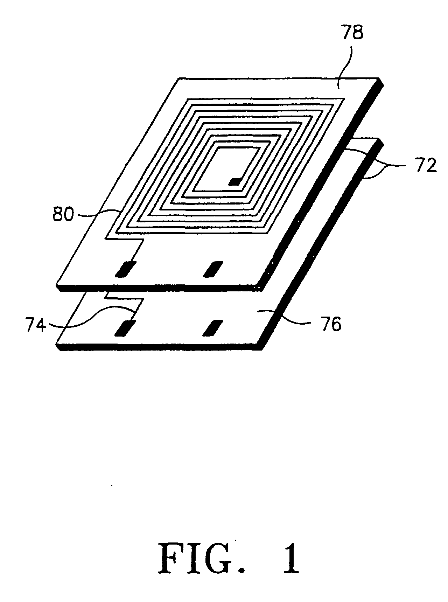

FIG. 1 is a perspective view showing the structure of a PCB transformer according to an embodiment of the invention.

As shown in FIG. 1, the PCB transformer 72 has a pair of windings installed on PCB circuits, and includes first and second sides 76 and 78, respectively. Sides 76 and 78 are placed parallel to each other having a certain distance in the vertical direction so that the first and second sides 76 and 78 are magnetically coupled thereby enabling a non-contact charge. First side 76 includes winding 74 and second side 78 includes winding 80. Windings 74 and 80 extend radially outwardly from the center as shown.

The most prominent advantage of the PCB transformer 72 is that it can be manufactured as a low-profile device, where the size and shape of the PCB transformer can be modified according to application devices. Also, since the PCB transformer 72 does not use a magnetic coil, the manufacturing cost is cheap and the mechanical strength is very high. The PCB transformer 72 can be further reduced in weight and height if manufactured using a flexible PCB.

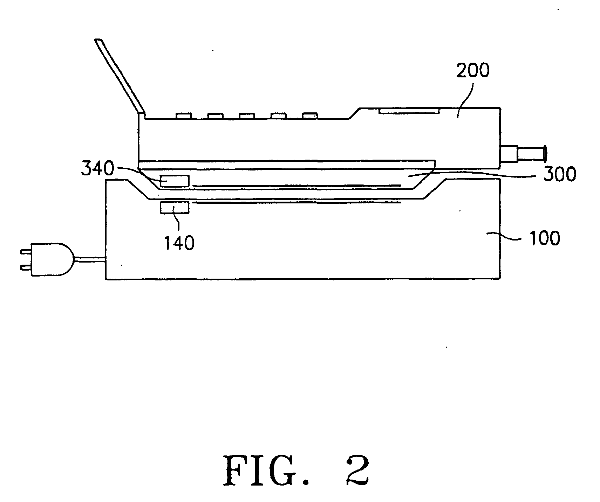

FIG. 2 is a side elevational view of a non-contact battery charger for a mobile telephone using PCB transformer 72 shown in FIG. 1.

A converter 100 converts normal power to a square wave which is suitable for actuating PCB transformer 72. At the upper side of converter 100, first side 76 of PCB transformer 72 shown in FIG. 1 is installed.

The second side 78 of PCB transformer 72 shown in FIG. 1 is installed on the surface of a battery pack 300 which is installed in a mobile telephone 200. Also, a circuit necessary for charging and controlling the battery is manufactured in compact size and installed within the battery pack 300.

The telephone 200 is settled on the upper side of converter 100 with battery pack 300 being oriented downward so that a non-contact charge is started at the battery pack 300. Charging is accomplished through contacts 140 and 340.

Such a charging method enables a non-contact charge without influencing the shape and the size of the mobile telephone or the battery pack which are currently used. This charging method can be applied to portable information communication and calculation devices such as a PDA, a palm-top, an internetphone, etc. as well as mobile telephones.

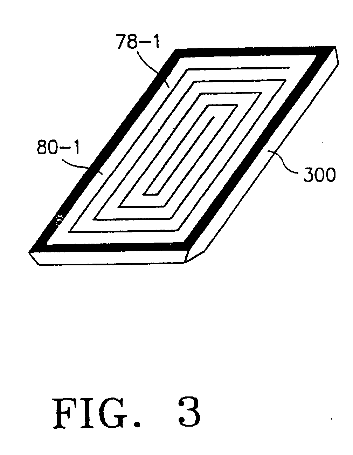

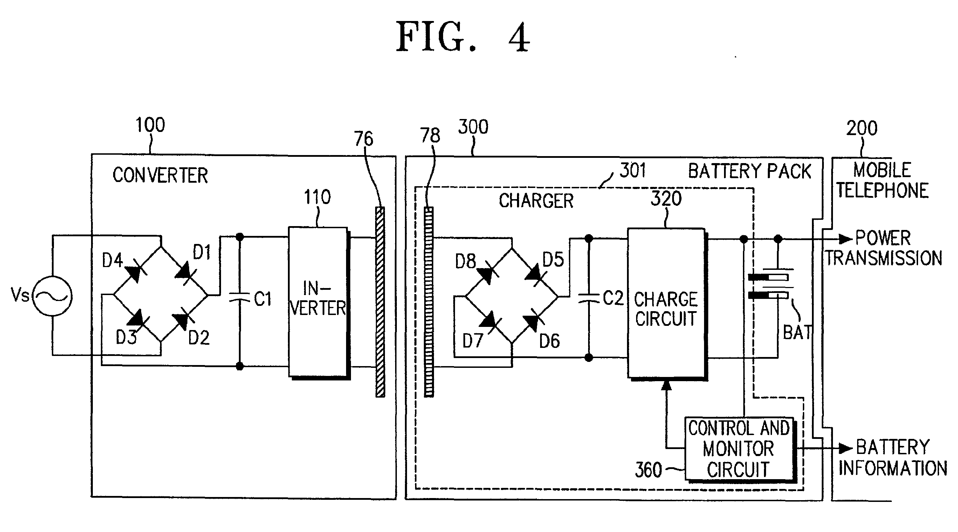

FIG. 3 is a perspective view showing the second side 78 of PCB transformer 72 shown in FIG. 1, which is mounted to the surface of battery pack 300. FIG. 4 is a schematic view showing the structure of the non-contact battery charger for mobile telephone 200 according to an embodiment of the invention.

Referring to Fig. 4, the non-contact charger is comprised of the converter 100 including the first side 76 of PCB transformer 72, and a charger 301 including the second side 78 of PCB transformer 72.

The second side 78 of PCB transformer 72 is mounted on the surface of the battery pack 300, and a circuit related to the charger 301 is installed within the battery pack 300. The charger 301 is indicated by the dotted line.

The converter 100 is comprised of diodes D1 to D4, an output capacitor C1, an inverter 110 and the first side 76 of PCB transformer 72.

A supply voltage Vₛ applied to the converter 100, is converted to DC via the rectifier circuit comprising the diode rectifiers D1 to D4 and an output capacitor C1, and then the rectified DC voltage is applied to an input terminal of the inverter 110. DC current applied to the inverter 110 is converted into a high frequency square wave and then applied to the first side 76 of PCB transformer 72.

The square wave applied to the first side 76 of PCB transformer 72 generates a magnetic field, which induces an electromotive force to the second side 78 of PCB transformer 72. The electromotive force induced to the second side 78 of PCB transformer 72 is converted to a DC voltage via a rectifier circuit comprised of diodes D5 to D8 and a capacitor C2, and then applied to a charge circuit 320.

The charge circuit 320 converts the input voltage into a lower voltage to apply the same to a Li ion battery BAT. A control/monitor circuit 360 detects a voltage or current signal of the battery BAT, and based upon the detected signal, generates a suitable signal which is supplied to the charge circuit 320. Also, the control/monitor circuit 360 detects a voltage of the battery BAT to inspect charge/discharge states of the battery BAT and transmits information about the battery state to the mobile telephone. Battery BAT provides power to terminal 200.

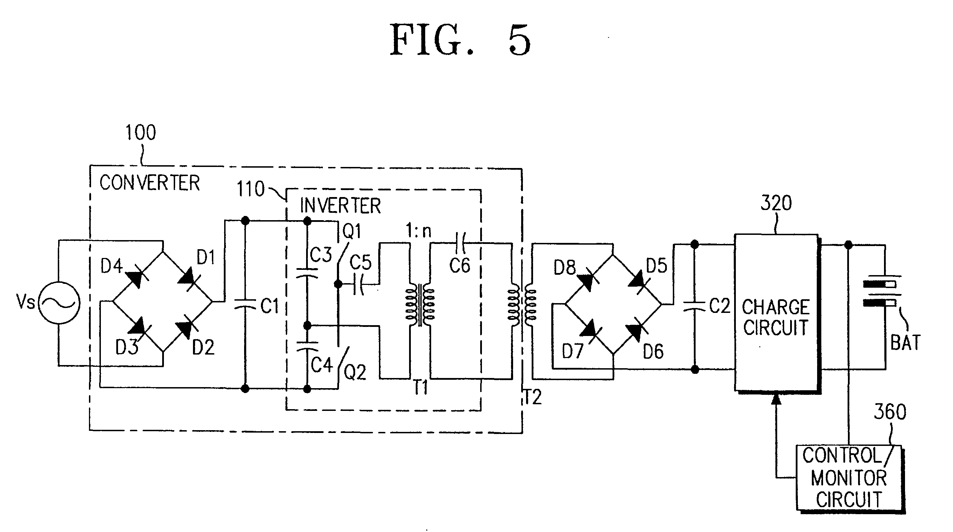

FIG. 5 is a detailed view of the circuit of inverter 110 of the non-contact battery charger for a mobile telephone according to another embodiment of the invention. In this embodiment, inverter 110 is constructed of a half-bridge series resonant inverter. The reference numerals C3 and C4 are capacitors for bisecting an input voltage, and Q1 and Q2 are MOS-type field effect transistor switches. The reference numeral T1 is a common step-down transformer using a magnetic core, and T2 is a PCB transformer according to the embodiment of the invention.

The voltage applied to both ends of the capacitor C1 is bisected by capacitors C3 and C4, converted into square waves via switching functions of the switches Q1 and Q2, and then applied to first side of the step-down transformer T1 via a capacitor C5. Here, the capacitor C5 interrupts a DC component, and the transformer T1 reduces the size of a square wave applied to a first side of the PCB transformer T2.

A capacitor C6 is a resonant capacitor, and is associated with a leakage inductance of the PCB transformer T2 to construct a series resonant circuit. The voltage induced to a second side of the PCB transformer T2 is applied to a charge circuit 320 via the rectifier circuit D5-D8. The inverter 110 adopts a circuit form which can effectively compensate for a disadvantage associated with the PCB transformer T2 as follows:

First, the step-down transformer prevents inefficiency of the circuit, The magnetizing inductance of PCB transformer T2 is very small compared to this of common transformers. Therefore, if the step-down transformer T1 is not used, a magnetizing current is excessively increased so that the efficiency of the inverter reduces.

Second, the PCB transformer T2 has a leakage inductance which is relatively larger compared to those of common transformers. Therefore, the inverter 110 utilizes the leakage inductance of the PCB transformer T2 as a resonant inductance to enhance efficiency of the circuit.

While the invention has been described with reference to detailed embodiments of the present invention in the foregoing specification, it is apparent that various modifications can be made. Therefore, the scope of the invention shall not be restricted by the foregoing embodiments, but rather is set forth in the following claims.

## Claims

1. A printed circuit board (PCB) transformer for use in a battery charger for charging a portable electronic device, comprising: a first PCB having a first winding; and a second PCB having a second winding and being distanced in a plane parallel from the first PCB, such that the first PCB does not contact the second PCB.

2. The PCB transformer according to claim 1, wherein the first PCB comprises a first side of the PCB transformer, and wherein the second PCB comprises a second side of the PCB transformer.

3. The PCB transformer according to claim 1 or 2, wherein each of the first and second windings extend radially from a center of a surface of each of the PCBs.

4. A non-contact battery charger comprising:
a PCB transformer having a first PCB including a first winding thereon, and a second PCB having a second winding thereon;
a converter including the first PCB for converting a supply voltage into a high frequency square wave and applying the converted square wave to the first winding of the first PCB of the PCB transformer; and
a charger having a charge circuit for converting an input voltage to a lower voltage and supplying the converted voltage to a battery and the second PCB of the PCB transformer, wherein the charger is adapted to convert an electromotive force to a DC voltage to apply the converted DC voltage to said charge circuit, the electromotive force being induced in the second winding of the second PCB of the PCB transformer by a magnetic wave which is generated by the square wave induced in the first winding of the first PCB of the PCB transformer.

5. The non-contact battery charger according to claim 4, wherein said charger is provided within a battery pack.

6. The non-contact battery charger according to claim 5, wherein the second PCB is provided on an internal surface of said battery pack.

7. The non-contact battery charger according to claim 5 or 6, wherein said battery pack is provided in a mobile telephone to supply a voltage to an internal battery as operating power.

8. The non-contact battery charger according to one of the claims 4 to 7, wherein said converter includes a rectifier circuit for rectifying the supply voltage to be converted into a DC voltage; and an inverter for converting the DC voltage to the high frequency square wave to apply the converted square wave to the first winding of the first PCB of the PCB transformer.

9. The non-contact battery charger according to claim 8, wherein said rectifier circuit comprises diode rectifiers connected to a supply voltage input end and an output capacitor connected between said diode rectifiers and said inverter.

10. The non-contact battery charger according to claim 8 or 9, wherein said converter further comprises a half-bridge series resonant inverter.

11. The non-contact battery charger according to claim 10, wherein said inverter has two capacitors for bisecting an input voltage; two switches for converting the bisected voltage to square waves according to switching operation; and a step-down transformer using a magnetic core for reducing the size of the square waves applied to the first winding of the PCB transformer.

12. The non-contact battery charger according to claim 11, wherein each of said switches is an MOS-type field effect transistor switch.

13. The non-contact battery charger according to claim 11 or 12, further comprising a capacitor for interrupting a DC component between connection points of said switches and a first side of said step-down transformer.

14. The non-contact battery charger according to claim 13, further comprising a resonant capacitor connected between a second side of said step-down transformer and said first side of the PCB transformer and coupled with a leakage inductance of the PCB transformer to form a series resonant circuit.

15. The non-contact battery charger according to one of the claims 4 to 14, further comprising a control and monitor circuit for detecting voltage and current of said battery and generating a control signal based upon the detected signal to supply the control signal to said charge circuit.

16. The non-contact battery charger according to claim 15, wherein said control and monitor circuit is adapted to detect a voltage of said battery to inspect a charge/discharge state of said battery, and to transmit information about the battery state to a communication terminal which is supplied with operating power from said battery.

17. The non-contact battery charger according to one of the claims 4 to 14, further comprising a control and monitor circuit for detecting voltage of said battery to inspect a charge/discharge state of said battery and transmitting information about the battery state to a communication terminal which is supplied with operating power from said battery.

18. The non-contact battery charger according to claim 16 or 17, wherein said communication terminal is a mobile telephone.

19. The non-contact battery charger according to one of the claims 4 to 18, wherein said battery is a Li ion battery.

20. The non-contact battery charger according to one of the claims 4 to 19, wherein the first winding extends radially from a center of the first PCB; and the second winding extends radially from a center of the second PCB, wherein the second PCB is spaced parallel to the first PCB in a vertical direction.

21. A non-contact battery charger comprising:
a PCB transformer including a first side having a first winding extending radially from a center of the first side of the PCB transformer;
a first rectifier circuit for converting a power voltage to be applied into a DC voltage, and an inverter for converting the DC voltage into a square wave to apply the converted square wave to the first side of the PCB transformer;
a charger having a second side of the PCB transformer, the second side having a second winding extending radially from a center of the second side of the PCB transformer, the first side being spaced parallel from the second side of the PCB transformer a certain distance in a vertical direction; and
a second rectifier circuit for converting an electromotive force to a DC voltage to apply the converted DC voltage to a charge circuit, the electromotive force being induced to a winding in the second side of the PCB transformer by a magnetic wave which is generated by the square wave induced to the first side of the PCB transformer, the charger further having a charge circuit for converting an input voltage from the second rectifier circuit to a lower voltage to supply the converted input voltage to a battery.
